# EUROPEAN PATENT APPLICATION

(11) **EP 4 516 958 A1**
(43) Date of publication of application: **05.03.2025**
(21) Application number: 23796884.7
(22) Date of filing: 28.04.2023
(51) Int. Cl.: C23C 14/16

(54) **SILICON-COATED ANTIOXIDANT IRON, SILICON-COATED ANTIOXIDANT NICKEL, AND MANUFACTURING METHOD THEREFOR**

(30) Priority: 28.04.2022 KR 20220053024; 28.04.2022 KR 20220053027
(71) Applicant: Pusan National University Industry-University Cooperation Foundation, Busan 46241 (KR)
(72) Inventor: JEONG, Se Young, Busan 46241 (KR); KIM, Su Jae, Busan 46241 (KR)
(74) Representative: Gulde & Partner
(86) International application number: PCT/KR2023/005871
(87) International publication number: WO 2023/211245

(57) **Abstract**

The present invention relates to silicon-coated antioxidant iron, silicon-coated antioxidant nickel, and manufacturing methods therefor. More specifically, the present invention relates to an antioxidant iron that includes a surface coated with silicon (Si) by depositing silicon (Si) to form a silicon (Si)-oxygen (O)-iron (Fe) mixed layer protective film and preserve the electrical properties while exhibiting resistance to oxidation, an antioxidant nickel that includes a surface coated with silicon (Si) by depositing silicon (Si) to form a silicon (Si)-oxygen (O)-nickel (Ni) mixed layer protective film and preserves electrical properties while exhibiting resistance to oxidation, and manufacturing methods therefor. The silicon-coated antioxidant iron according to the present invention is characterized by comprising: an iron layer (10); an iron oxide (Fe₃O₄) layer (20) formed on iron layer (10); a SiFeX layer (30) including a mixture of silicon (Si)-oxygen (O)-iron (Fe) and formed on the iron oxide layer (20); and a silicon (Si)-oxygen (O) mixture layer (40) formed on the SiFeX layer (30). The method for manufacturing silicon-coated iron according to the present invention is characterized in that silicon (Si) is deposited through a single sputtering process. The silicon-coated antioxidant nickel according to the present invention is characterized by comprising: a nickel layer (100); a SiNiX layer (200) including a mixture of silicon (Si)-oxygen (O)-Nickel (Ni) and formed on the nickel layer (100); a first silicon (Si)-oxygen (O) mixed layer (300) formed on the SiNiX layer (200); and a second silicon (Si)-oxygen (O) mixed layer (400) formed on the first silicon (Si)-oxygen (O) mixed layer (300). The method for manufacturing silicon-coated nickel according to the present invention is characterized in that silicon (Si) is deposited through a single sputtering process.

## Description

### Technical Field

The present invention relates to a silicon-coated oxidation-resistant iron, a silicon-coated oxidation-resistant nickel, and methods for producing the same, and more specifically, to an oxidation-resistant iron including a silicon (Si)-coated surface, which has resistance to oxidation while maintaining its electrical properties by including a silicon (Si)-oxygen (O)-iron (Fe) mixed layer as a protective layer formed by depositing silicon (Si), an oxidation-resistant nickel including a silicon (Si)-coated surface, which has resistance to oxidation while maintaining its electrical properties by including a silicon (Si)-oxygen (O)-nickel (Ni) mixed layer as a protective formed by depositing silicon (Si), and methods for producing the same.

### Background Art

In general, metal materials are oxidized and corroded by interaction with the surrounding environment, which reduces the durability of the metals themselves. Conventional methods for preventing metal corrosion include a method of making chemically stable alloys by adding other elements to metals, and a method of treating metal surfaces by coating, etc.

The above-described method of coating the surface may use a coating material selected depending on the properties and intended use of the metal and the surrounding environment, and has the advantage of being able to improve corrosion resistance, but the use thereof at high temperatures is disadvantageously limited.

Therefore, in order to solve the above-described problem, a metal surface-coating method, which is simple in process and is capable of overcoming the oxidation problem, is required.

### DISCLOSURE

### Technical Problem

The present invention has been made in order to solve the above-described problem, and an object of the present invention is to provide a method for producing an oxidation-resistant iron thin film that is stable against oxidation even at high temperatures and prevented from oxidation by including a Si-O-Fe protective layer formed by Si deposition.

The present invention has been made in order to solve the above-described problem, and an object of the present invention is to provide a method for producing an oxidation-resistant nickel thin film that is stable against oxidation even at high temperatures and prevented from oxidation by including a Si-O-Ni protective layer formed by Si deposition.

Objects of the present invention are not limited to the objects mentioned above, and other objects not mentioned may be clearly understood by those skilled in the art to which the present invention pertains from the following description.

### Technical Solution

The present invention relates to a silicon-coated oxidation-resistant iron, and particularly, to a silicon-coated oxidation-resistant iron including a silicon (Si)-oxygen (O)-iron (Fe) mixed layer formed by depositing silicon (Si).

In one embodiment, the silicon-coated iron may have an electrical resistance similar to that of non-silicon (Si)-coated iron.

In one embodiment, the silicon-coated iron may be in the form of a thin film, a foil, or a bulk.

In one embodiment, when the silicon-coated iron is in the form of a thin film, a foil, or a bulk, it may be prevented from oxidation even when heated to 200 to 350°C for 20 minutes to 40 minutes.

In one embodiment, the silicon-coated iron may have a sheet resistance of 9.2 x 10⁻⁴ to 9.6 x 10⁻⁴ Ω/□.

In one embodiment, the silicon-coated iron may be composed of: an iron layer 10; an iron oxide (Fe₃O₄) layer 20 formed on the iron layer 10; a SiFeOₓ layer formed on the iron oxide layer 20 and consisting of a mixture of (Si)-oxygen (O)-iron (Fe); and a silicon (Si)-oxygen (O) mixed layer 40 formed on the SiFeOₓ layer 30.

In one embodiment, the iron oxide (Fe₃O₄) layer 20 may have a thickness of 3 to 7 nm.

In one embodiment, the SiFeOₓ layer 30 consisting of the mixture of (Si)-oxygen (O)-iron (Fe) may have a thickness of 0.8 to 1.2 nm.

In one embodiment, the silicon (Si)-oxygen (O) mixed layer 40 may have a thickness of 5 to 30 nm.

The present invention relates to a method of producing a silicon-coated oxidation-resistant iron by depositing silicon (Si) on iron (Fe) by a single sputtering process.

In one embodiment, the sputtering may be performed under an argon atmosphere.

In one embodiment, the sputtering may be performed at room temperature to 350°C for 1 to 5 minutes.

The present invention relates to a silicon-coated oxidation-resistant nickel, and particularly, to a silicon-coated oxidation-resistant nickel including a SiNiOₓ layer 200 which is a silicon (Si)-oxygen (O)-nickel (Ni) mixed layer formed by depositing silicon (Si).

In one embodiment, the silicon-coated nickel may have an electrical resistance similar to that of non-silicon (Si)-coated nickel.

In one embodiment, the silicon-coated nickel may be in the form of a single-crystal thin film, a polycrystalline thin film, a foil, or a bulk.

In one embodiment, when the silicon-coated nickel is in the form of a single-crystal thin film, it may be prevented from oxidation even when heated to 300 to 500°C for 20 minutes to 50 minutes.

In one embodiment, when the silicon-coated nickel is in the form of a polycrystalline thin film, a foil, or a bulk, it may be prevented from oxidation even when heated to 300 to 400°C.

In one embodiment, the silicon-coated nickel may have a sheet resistance of 6.2 x 10⁻⁴ to 6.8 x 10⁻⁴ Ω/□.

In one embodiment, the silicon-coated nickel may be composed of: a nickel layer 100; a SiNiOₓ layer 200 formed on the nickel layer 100 and consisting of a mixture of silicon (Si)-oxygen (O)-nickel (Ni); a first silicon (Si)-oxygen (O) mixed layer 300 formed on the SiNiOₓ layer 200; and a second silicon (Si)-oxygen (O) mixed layer 400 formed on the first silicon (Si)-oxygen (O) mixed layer 300.

In one embodiment, the SiNiOₓ layer 200 may have a thickness of 0.8 to 1.2 nm.

In one embodiment, a silicon (Si)-oxygen (O) mixed layer including the first silicon (Si)-oxygen (O) mixed layer 300 and the second silicon (Si)-oxygen (O) mixed layer 400 may have a thickness of 5 to 30 nm.

The present invention relates to a method of producing a silicon-coated oxidation-resistant nickel by depositing silicon (Si) on nickel (Ni) by a single sputtering process.

In one embodiment, the sputtering may be performed under an argon atmosphere.

In one embodiment, the sputtering may be performed at room temperature to 350°C for 1 to 5 minutes.

### Advantageous Effects

According to the "Technical Solution", the present invention may produce an iron free from oxidation through a simple process with high efficiency, merely by depositing silicon (Si), and may provide an oxidation-resistant iron with high economic value using iron (Fe) and silicon (Si).

In addition, the present invention may provide an iron (Fe) which has resistance to oxidation while maintaining its electrical properties by including a silicon (Si)-oxygen (O)-iron (Fe) protective layer formed by silicon (Si) deposition, and a method for producing the same.

In addition, the present invention may provide an oxidation-resistant iron that is produced in a very simple manner, is inexpensive, and may be used semi-permanently at room temperature.

In addition, the present invention may provide an oxidation-resistant iron having significantly increased resistance to oxidation at high temperatures.

In addition, the present invention may produce a nickel free from oxidation through a simple process with high efficiency, merely by depositing silicon (Si), and may provide an oxidation-resistant nickel with high economic value using iron (Fe) and silicon (Si).

In addition, the present invention may provide a nickel (Ni) which has resistance to oxidation while maintaining its electrical properties by including a silicon (Si)-oxygen (O)-nickel (Ni) protective layer formed by silicon (Si) deposition, and a method for producing the same.

In addition, the present invention may provide an oxidation-resistant nickel that is produced in a very simple manner, is inexpensive, and may be used semi-permanently at room temperature.

In addition, the present invention may provide an oxidation-resistant nickel having significantly increased resistance to oxidation at high temperatures.

Effects of the present disclosure are not limited to the effects mentioned above, and other effects not mentioned above may be clearly understood by those skilled in the art from the appended claims.

### Brief Description of Drawings

FIG. 1 depicts photographs of an uncoated iron plate and a silicon (Si)-coated iron plate according to the present invention before and after heat treatment.
FIG. 2 depicts graphs showing the results of XRD measurements of an uncoated iron plate and a silicon-coated iron plate according to the present invention before and after heat treatment.
FIG. 3 depicts graphs showing the results of SEM measurements of an uncoated iron plate and a silicon-coated iron plate according to the present invention before and after heat treatment.
FIG. 4(a) depicts TEM images of the cross-section of a silicon-coated iron plate according to the present invention, FIG. 4(b) is an image showing the results of analyzing components on the sample surface by TEM, and FIG. 4(c) depicts graphs showing the results of analyzing components on the sample surface by TEM.
FIG. 5 is a graph showing the results of measuring the sheet resistance of an uncoated iron plate and a silicon-coated iron plate according to the present invention before and after heat treatment.
FIG. 6 depicts photographs showing the predicted distribution of O (red) and Si (blue) on an Fe (gold color) thin layer of a silicon-coated iron plate according to the present invention. (a): a side view, and (b): a plan view.
FIG. 7 is a graph showing the predicted ΔE and atomic distribution as a function of the penetration depth of oxygen into each of an uncoated iron plate and a silicon-coated iron plate according to the present invention.
FIG. 8 depicts photographs of an uncoated nickel plate and a silicon (Si)-coated nickel plate according to the present invention before and after heat treatment.
FIG. 9 depicts graphs showing the results of XRD measurements of an uncoated nickel plate and a silicon-coated nickel plate according to the present invention before and after heat treatment.
FIG. 10 depicts graphs showing the results of SEM measurements of an uncoated nickel plate and a silicon-coated nickel plate according to the present invention before and after heat treatment.
FIG. 11(a) depicts TEM images of the cross-section of a silicon-coated nickel iron plate according to the present invention, FIG. 11(b) is an image showing the results of analyzing components on the sample surface by TEM, and FIG. 11(c) depicts graphs showing the results of analyzing components on the sample surface by TEM.
FIG. 12 is a graph showing the results of measuring the sheet resistance of an uncoated nickel plate and a silicon-coated nickel plate according to the present invention before and after heat treatment.
FIG. 13 depicts photographs showing the predicted distribution of O (red) and Si (gray) on a Ni (green) thin layer of a nickel-coated iron plate according to the present invention. (a): a side view, and (b): a plan view.
FIG. 14 is a graph showing the predicted ΔE and atomic distribution as a function of the penetration depth of oxygen into each of an uncoated nickel plate and a silicon-coated nickel plate according to the present invention.

### Best Mode

Terms used in the present specification are currently widely used general terms selected in consideration of their functions in the present disclosure, but they may change depending on the intents of those skilled in the art, precedents, or the advents of new technology. Additionally, in certain cases, there may be terms arbitrarily selected by the applicant, and in this case, their meanings are described in a corresponding description part of the present disclosure. Accordingly, terms used in the present disclosure should be defined based on the meaning of the term and the entire contents of the present disclosure, rather than the simple term name.

Unless otherwise defined, all terms used herein, including technical or scientific terms, have the same meanings as understood by those skilled in the art to which the present disclosure pertains. Terms such as those used in general and defined in dictionaries should be interpreted as having meanings identical to those specified in the context of related technology. Unless definitely defined in the present application, the terms should not be interpreted as having ideal or excessively formative meanings.

A numerical range includes numerical values defined in the range. Every maximum numerical limitation given throughout the present specification includes every lower numerical limitation, as if such lower numerical limitations were expressly written herein. Every minimum numerical limitation given throughout the present specification will include every higher numerical limitation, as if such higher numerical limitations were expressly written herein. Every numerical range given throughout this specification will include every narrower numerical range that falls within such broader numerical range, as if such narrower numerical ranges were all expressly written herein.

### Silicon-Coated Oxidation-Resistant Iron

The present invention relates to a silicon-coated oxidation-resistant iron, and particularly, to an oxidation-resistant iron including a silicon (Si)-oxygen (O)-iron (Fe) mixed layer formed by depositing silicon.

The oxidation-resistant iron with the mixed layer formed may have resistance to oxidation while maintaining its electrical properties.

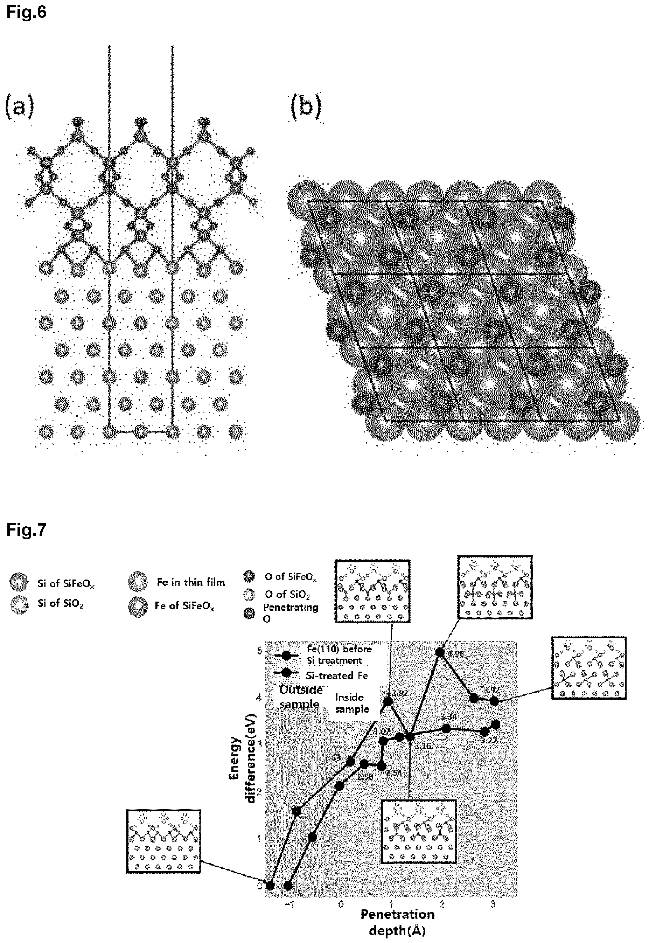

As the mixed layer is formed, the iron may be prevented from additional oxidation other than oxidation of the iron oxide layer and have resistance to oxidation at high temperatures. The silicon may function to bind to the oxygen on the iron surface and fix the oxygen to the iron surface, and in this case, the most basic structure may be configured as shown in FIG. 6. As shown in the side view of the FIG. 6(a) and the plan view of FIG. 6(b), after the oxygen covers the iron surface and is fixed by the silicon, other oxygen atoms may not enter the iron, so that the iron can have oxidation resistance.

In the present invention, the silicon-coated iron may have an electrical resistance between that of non-silicon (Si)-coated iron (Si) and that of gold (Au).

In the present invention, the silicon-coated iron may be in the form of a polycrystalline thin film, a foil, or a bulk.

In the present invention, when the silicon-coated iron is in the form of a polycrystalline thin film, a foil, or a bulk, it may be prevented from oxidation even when heated to 200 to 400°C for 20 to 40 minutes. When the iron is in the form of a polycrystalline thin film, a foil, or a bulk, it may be prevented from oxidation, and thus even when it is subjected to heat treatment as described above, it may show no visible change in color, as well as no change in XRD measurement or SEM measurement results.

The present invention relates to a silicon-coated oxidation-resistant iron, and particularly, to a SiFeOₓ layer which is a silicon (Si)-oxygen (O)-iron (Fe) mixed layer formed by depositing silicon (Si).

The oxidation-resistant iron with the SiFeOₓ layer formed may have resistance to oxidation while maintaining its electrical and magnetic properties.

As the SiFeOₓ layer is formed, the iron may be prevented from additional oxidation other than oxidation of the iron oxide layer and have resistance to oxidation at high temperatures. The silicon may function to bind to the oxygen on the iron surface and fix the oxygen to the iron surface, and in this case, the most basic structure may be configured as shown in FIG. 6. As shown in the side view of the FIG. 6(a) and the plan view of FIG. 6(b), after the oxygen covers the iron surface and is fixed by the silicon, other oxygen atoms may not enter the iron, so that the iron can have oxidation resistance.

In the present invention, the silicon-coated iron may have an electrical resistance similar to that of non-silicon (Si)-coated iron.

In the present invention, the silicon-coated iron may be in the form of a thin film, a foil, or a bulk.

In the present invention, when the silicon-coated iron is in the form of a thin film, a foil, or a bulk, it may be prevented from oxidation even when heated to 200 to 350°C for 20 to 40 minutes. When the iron is in the form of a thin film, a foil, or a bulk, it may be prevented from oxidation, and thus even when it is subjected to heat treatment as described above, it may show no visible change in color, as well as no change in XRD measurement or SEM measurement results.

In the present invention, the silicon-coated iron may have a sheet resistance of 9.2 x 10⁻⁴ to 9.6 x 10⁻⁴ Ω/□. The silicon-coated iron may have a sheet resistance similar to that of non-silicon-coated iron, and the sheet resistance may not increase sharply even after heat treatment.

In the present invention, the silicon-coated iron may be composed of: an iron layer 10; an iron oxide (Fe₃O₄) layer 20 formed on the iron layer 10; a SiFeOₓ layer formed on the iron oxide layer 20 and consisting of a mixture of (Si)-oxygen (O)-iron (Fe); and a silicon (Si)-oxygen (O) mixed layer 40 formed on the SiFeOₓ layer 30.

In the present invention, the iron oxide (Fe₃O₄) layer 20 may have a thickness of 3 to 7 nm, preferably 3 to 5 nm. The iron oxide layer may be formed to have a very small thickness so as to have little effect on the corrosion resistance of the iron.

In the present invention, the SiFeOₓ layer 30 consisting of the mixture of (Si)-oxygen (O)-iron (Fe) may have a thickness of 0.8 to 1.2 nm.

In the present invention, the silicon (Si)-oxygen (O) mixed layer 40 may have a thickness of 5 to 30 nm, preferably 8 to 20 nm.

### Method for Producing Silicon-Coated Oxidation-Resistant Iron

The present invention relates to a method for producing a silicon-coated oxidation-resistant iron.

The silicon-coated oxidation-resistant iron of the present invention is an oxidation-resistant iron including a SiFeOₓ layer which is a silicon (Si)-oxygen (O)-iron (Fe) mixed layer formed by depositing silicon.

The oxidation-resistant iron with the SiFeOₓ layer formed may have resistance to oxidation while maintaining its electrical properties.

As the SiFeOₓ layer is formed, the iron may be prevented from additional oxidation other than oxidation of the iron oxide layer and have resistance to oxidation at high temperatures. The silicon may function to bind to the oxygen on the iron surface and fix the oxygen to the iron surface, and in this case, the most basic structure may be configured as shown in FIG. 6. As shown in the side view of the FIG. 6(a) and the plan view of FIG. 6(b), after the oxygen covers the iron surface and is fixed by the silicon, other oxygen atoms may not enter the iron, so that the iron can have oxidation resistance.

In the present invention, the silicon-coated iron may have an electrical resistance similar to that of non-silicon (Si)-coated iron.

In the present invention, the silicon-coated iron may be in the form of a thin film, a foil, or a bulk.

In the present invention, when the silicon-coated iron is in the form of a thin film, a foil, or a bulk, it may be prevented from oxidation even when heated to 200 to 350 °C for 20 to 40 minutes. When the iron is in the form of a thin film, a foil, or a bulk, it may be prevented from oxidation, and thus even when it is subjected to heat treatment as described above, it may show no visible change in color, as well as no change in XRD measurement or SEM measurement results.

In the present invention, the silicon-coated iron may have a sheet resistance of 9.2 x 10⁻⁴ to 9.6 x 10⁻⁴ Ω/□. The silicon-coated iron may have a sheet resistance similar to that of non-silicon-coated iron, and the sheet resistance may not increase sharply even after heat treatment.

In the present invention, the silicon-coated iron may be composed of: an iron layer 10; an iron oxide (Fe₃O₄) layer 20 formed on the iron layer 10; a SiFeOₓ layer formed on the iron oxide layer 20 and consisting of a mixture of (Si)-oxygen (O)-iron (Fe); and a silicon (Si)-oxygen (O) mixed layer 40 formed on the SiFeOₓ layer 30.

In the present invention, the iron oxide (Fe₃O₄) layer 20 may have a thickness of 3 to 7 nm. The iron oxide layer may be formed to have a very small thickness so as to have little effect on the corrosion resistance of the iron.

In the present invention, the SiFeOₓ layer 30 consisting of the mixture of (Si)-oxygen (O)-iron (Fe) may have a thickness of 0.8 to 1.2 nm.

In the present invention, the silicon (Si)-oxygen (O) mixed layer 40 may have a thickness of 5 to 30 nm, preferably 8 to 20 nm.

The present invention relates to a method of producing a silicon-coated oxidation-resistant iron by depositing silicon (Si) on iron (Fe) by a single sputtering process. The production method of the present invention is performed by the single process as described above, and thus may be very simple and economical.

In the present invention, the sputtering may be performed under an argon atmosphere.

In the present invention, the sputtering may be performed at room temperature to 350°C for 1 to 5 minutes. Preferably, the sputtering may be performed at 180 °C to 200 °C for 70 to 350 seconds. If the sputtering is performed at a temperature out of the above range for a time out of the above time range, the crystallinity of the iron deteriorates due to the formation of grain boundaries and dislocations. Thus, it is preferable to perform the sputtering at a temperature within the above range for a time within the above time range.

### Silicon-Coated Oxidation-Resistant Nickel

The present invention relates to a silicon-coated oxidation-resistant nickel, and particularly, to a silicon-coated oxidation-resistant nickel including a SiNiOₓ layer which is a silicon (Si)-oxygen (O)-nickel (Ni) mixed layer formed by depositing silicon.

The oxidation-resistant iron with the SiNiOₓ layer formed may have resistance to oxidation while maintaining its electrical properties.

**As** the SiNiOₓ layer is formed, the nickel may be prevented from oxidation and have resistance to oxidation at high temperatures. The silicon may function to bind to the oxygen on the nickel layer surface and fix the oxygen to the nickel surface, and in this case, the most basic structure may be configured as shown in FIG. 6. As shown in the side view of the FIG. 6(a) and the plan view of FIG. 6(b), after the oxygen covers the nickel surface and is fixed by the silicon, other oxygen atoms may not enter the nickel, so that the nickel can have oxidation resistance.

**In** the present invention, when the silicon-coated nickel is in the form of a single-crystal thin film, it may be prevented from oxidation even when heated to 300 to 500 °C for 20 to 50 minutes.

In the present invention, when the silicon-coated nickel is in the form of a polycrystalline thin film, a foil, or a bulk, it may be prevented from oxidation, and thus even when it is subjected to heat treatment as described above, it may show no visible change in color, as well as no change in XRD measurement or SEM measurement results.

In the present invention, the silicon-coated nickel may have a sheet resistance of 6.2 x 10⁻⁴ to 6.8 x 10⁻⁴ Ω/□. The silicon-coated nickel may have a sheet resistance similar to that of non-silicon-coated nickel, and the sheet resistance may not increase sharply even after heat treatment.

**In** the present invention, the silicon-coated nickel may be composed of: a nickel layer 100; a SiNiOₓ layer 200 formed on the nickel layer 100 and consisting of a mixture of silicon (Si)-oxygen (O)-nickel (Ni); a first silicon (Si)-oxygen (O) mixed layer 300 formed on the SiNiOₓ layer 200; and a second silicon (Si)-oxygen (O) mixed layer 400 formed on the first silicon (Si)-oxygen (O) mixed layer 300.

In the present invention, the SiNiOₓ layer 200 may have a thickness of 0.8 to 1.2 nm.

In the present invention, a silicon (Si)-oxygen (O) mixed layer including the first silicon (Si)-oxygen (O) mixed layer 300 and the second silicon (Si)-oxygen (O) mixed layer 400 may have a thickness of 5 to 30 nm, preferably 8 to 20 nm. The oxygen content of the first silicon (Si)-oxygen (O) mixed layer 300 may be higher than the nickel content thereof, and the nickel content of the second silicon (Si)-oxygen (O) mixed layer 400 may be higher than the oxygen content thereof.

### Method for Producing Silicon-Coated Oxidation-Resistant Nickel

**The** present invention relates to a method for producing a silicon-coated oxidation-resistant nickel.

**The** silicon-coated oxidation-resistant nickel of the present invention is an oxidation-resistant nickel including a SiNiOₓ layer 200 which is a silicon (Si)-oxygen (O)-nickel (Ni) mixed layer formed by depositing silicon. The present invention relates to a method for producing a silicon-coated oxidation-resistant nickel.

The silicon-coated oxidation-resistant nickel of the present invention is an oxidation-resistant nickel including a SiNiOₓ layer 200 which is a silicon (Si)-oxygen (O)-nickel (Ni) mixed layer formed by depositing silicon.

The oxidation-resistant nickel with the SiNiOₓ layer formed may have resistance to oxidation while maintaining its electrical properties.

As the SiNiOₓ layer is formed, the nickel may be prevented from oxidation and have resistance to oxidation at high temperatures. The silicon may function to bind to the oxygen on the nickel layer surface and fix the oxygen to the nickel surface, and in this case, the most basic structure may be configured as shown in FIG. 6. As shown in the side view of the FIG. 6(a) and the plan view of FIG. 6(b), after the oxygen covers the nickel surface and is fixed by the silicon, other oxygen atoms may not enter the nickel, so that the nickel can have oxidation resistance.

In the present invention, the silicon-coated nickel may have an electrical resistance similar to that of non-silicon-coated nickel.

In the present invention, the silicon-coated nickel may be in the form of a single-crystal thin film, a polycrystalline thin film, a foil, or a bulk.

In the present invention, when the silicon-coated nickel is in the form of a single-crystal thin film, it may be prevented from oxidation even when heated to 300 to 500 °C for 20 to 50 minutes.

In the present invention, when the silicon-coated nickel is in the form of a polycrystalline thin film, a foil, or a bulk, it may be prevented from oxidation even when heated to 200 to 400 °C. When the silicon-coated nickel is in the form of a polycrystalline thin film, a foil, or a bulk, it may be prevented from oxidation, and thus even when it is subjected to heat treatment as described above, it may show no visible change in color, as well as no change in XRD measurement or SEM measurement results.

In the present invention, the silicon-coated nickel may have a sheet resistance of 6.2 x 10⁻⁴ to 6.8 x 10⁻⁴ Ω/□. The silicon-coated nickel may have a sheet resistance similar to that of non-silicon-coated nickel, and the sheet resistance may not increase sharply even after heat treatment.

In the present invention, the silicon-coated nickel may be composed of: a nickel layer 100; a SiNiOₓ layer 200 formed on the nickel layer 100 and consisting of a mixture of silicon (Si)-oxygen (O)-nickel (Ni); a first silicon (Si)-oxygen (O) mixed layer 300 formed on the SiNiOₓ layer 200; and a second silicon (Si)-oxygen (O) mixed layer 400 formed on the first silicon (Si)-oxygen (O) mixed layer 300.

In the present invention, the SiNiOₓ layer 200 may have a thickness of 0.8 to 1.2 nm.

In the present invention, a silicon (Si)-oxygen (O) mixed layer including the first silicon (Si)-oxygen (O) mixed layer 300 and the second silicon (Si)-oxygen (O) mixed layer 400 may have a thickness of 5 to 30 nm, preferably 8 to 20 nm. The oxygen content of the first silicon (Si)-oxygen (O) mixed layer 300 may be higher than the nickel content thereof, and the oxygen content of the second silicon (Si)-oxygen (O) mixed layer 400 may be higher than the oxygen content thereof.

The present invention relates to a method of producing a silicon-coated oxidation-resistant nickel by depositing silicon (Si) on nickel (Ni) by a single sputtering process. The production method of the present invention is performed by the single process as described above, and thus may be very simple and economical.

In the present invention, the sputtering may be performed under an argon atmosphere.

In the present invention, the sputtering may be performed at room temperature to 350 °C for 1 to 5 minutes. Preferably, the sputtering may be performed at 180 °C to 200 °C for 70 to 350 seconds. If the sputtering is performed at a temperature out of the above range for a time out of the above time range, the crystallinity of the nickel deteriorates due to the formation of grain boundaries and dislocations. Thus, it is preferable to perform the sputtering at a temperature within the above range for a time within the above time range.

### Examples

Hereinafter, examples of the present invention will be described in detail, but it is obvious that the present invention is not limited to the following examples.

The advantages and features of the present invention, and the way of attaining them, will become apparent with reference to the examples described below in detail. However, the present invention is not limited to the examples disclosed below and may be embodied in a variety of different forms; rather, these examples are provided so that this disclosure will be thorough and complete, and will fully convey the scope of the present invention to those skilled in the art. The scope of the present invention will be defined by the appended claims.

### Example 1. Silicon-Coated Iron Plate

A silicon-coated iron plate was produced by depositing 20 nm of silicon (Si) on an iron (Fe) plate by sputtering under an argon atmosphere at 190 °C for 5 minutes.

### Comparative Example 1. Non-Silicon-Coated Iron Plate

A non-silicon-coated iron plate was prepared.

### Example 2. Silicon-Coated Nickel Plate

A silicon-coated nickel plate was produced by depositing 20 nm of silicon (Si) on a nickel (Fe) plate by sputtering under an argon atmosphere at 190 °C for 5 minutes.

### Comparative Example 2. Non-Silicon-Coated Nickel Plate

**A** non-silicon-coated nickel plate was prepared.

### Experimental Example 1. Observation of Degree of Oxidation after Heat Treatment

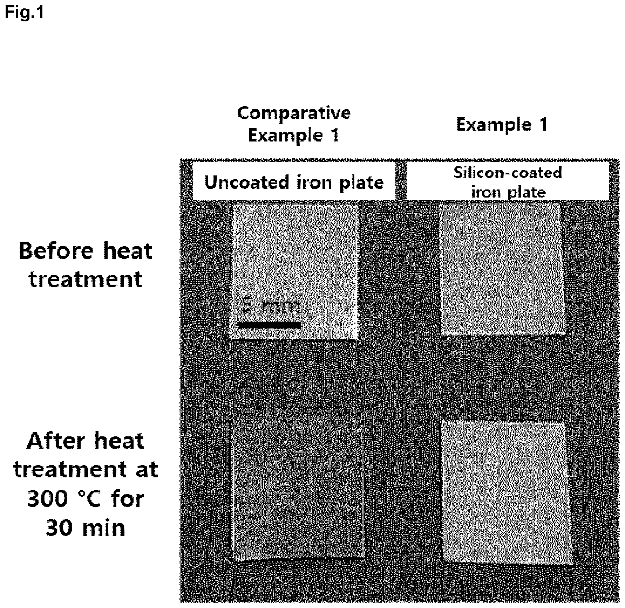

The iron plates prepared in Example 1 and Comparative Example 1 were heat-treated at 300 °C for 30 minutes and observed before and after the heat treatment, and the results are shown in FIG. 1.

As shown in FIG. 1, it was confirmed that the iron plate of Comparative Example 1 darkened due to oxidation after heat treatment, whereas the silicon-coated iron plate produced in Example 1 maintained its original color even after heat treatment, indicating that oxidation did not occur.

From the above results, it was confirmed that the silicon-coated iron according to the present invention had oxidation resistance.

In addition, the nickel plates prepared in Example 2 and Comparative Example 2 were heat-treated at 400 °C for 30 minutes and observed before and after the heat treatment, and the results are shown in FIG. 18

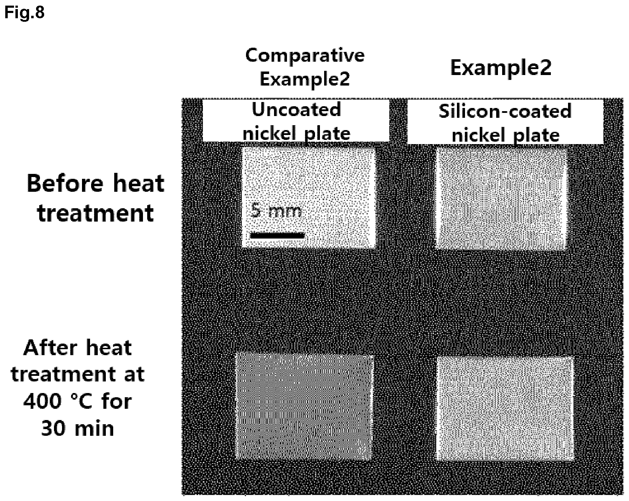

As shown in FIG. 8, it was confirmed that the nickel plate of Comparative Example 2 darkened due to oxidation after heat treatment, whereas the silicon-coated nickel plate produced in Example 2 maintained its original color even after heat treatment, indicating that oxidation did not occur.

From the above results, it was confirmed that the silicon-coated nickel according to the present invention had oxidation resistance.

### Experimental Example 2. XRD Measurement

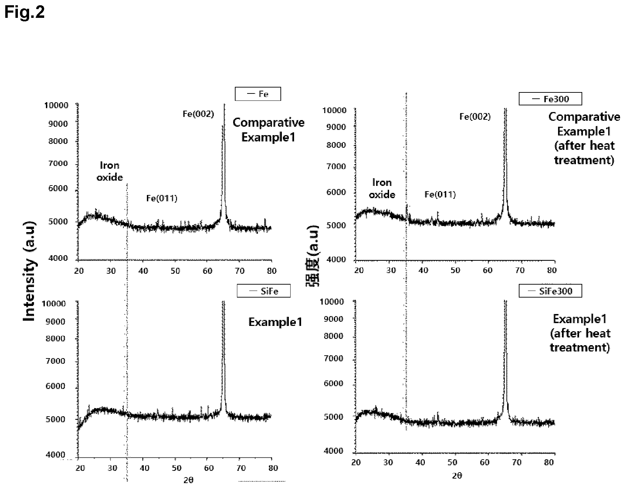

**The** iron plates prepared in Example 1 and Comparative Example 1 were heat-treated at 300 °C for 30 minutes and measured by XRD before and after the heat treatment, and the results are shown in FIG. 2.

As shown in FIG. 2, the silicon-coated iron plate produced in Example 1 did not show any peaks other than the peak of Fe before and after the heat treatment. In addition, the crystal structure thereof did not change. Thereby, it was confirmed that the silicon-coated iron plate was hardly oxidized after the heat treatment. On the other hand, in the case of the iron plate of Comparative Example 1, the iron oxide peak appeared after the heat treatment, indicating that oxidation had occurred. Although it is presumed that iron oxide (Fe₃O₄) was also formed on the silicon-coated iron plate of Example 1, but it is believed that iron oxide (Fe₃O₄) did not appear in the XRD results because it was formed to have a very small thickness because the oxidation reaction hardly occurred.

From the above results, it was confirmed that the silicon-coated iron according to the present invention had oxidation resistance.

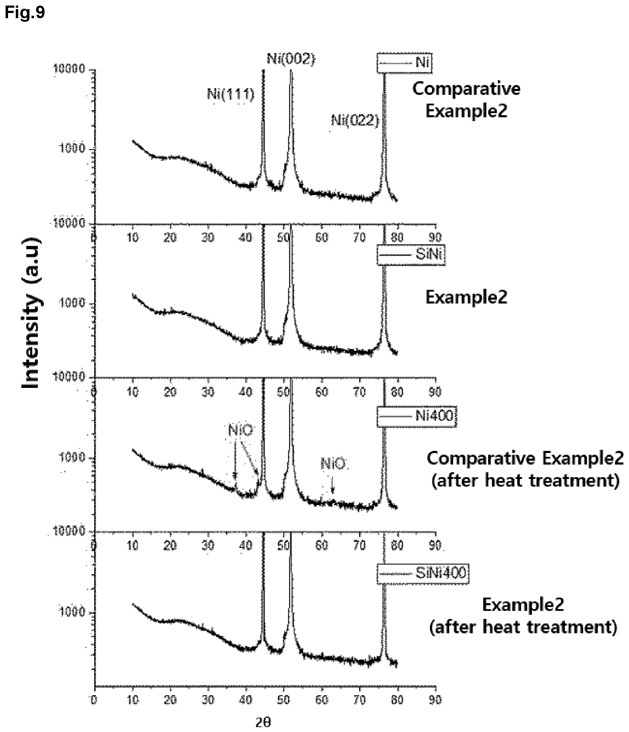

In addition, the nickel plates prepared in Example 2 and Comparative Example 2 were heat-treated at 400 °C for 30 minutes and measured by XRD before and after the heat treatment, and the results are shown in FIG. 9.

As shown in FIG. 9, the silicon-coated iron nickel produced in Example 2 did not show any peaks other than the peak of Ni before and after the heat treatment. In addition, the crystal structure thereof did not change. Thereby, it was confirmed that the silicon-coated nickel plate was hardly oxidized after the heat treatment. On the other hand, in the case of the nickel plate of Comparative Example 2, the nickel oxide peak appeared after the heat treatment, indicating that oxidation had occurred.

From the above results, it was confirmed that the silicon-coated nickel according to the present invention had oxidation resistance.

### Experimental Example 3. SEM Observation

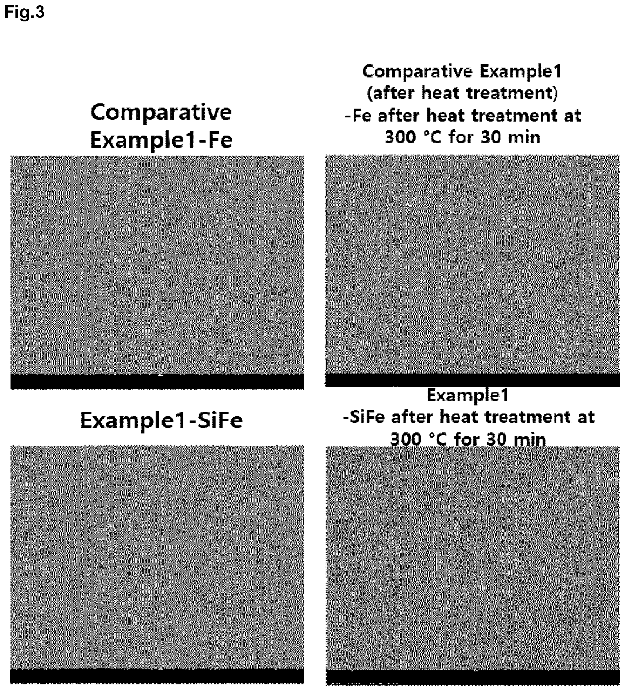

The iron plates prepared in Example 1 and Comparative Example 1 were heat-treated at 300 °C for 30 minutes and observed by SEM at 10,000x magnification before and after the heat treatment, and the results are shown in FIG. 3.

As shown in FIG. 3, the iron plate of Comparative Example 1 showed surface changes after the heat treatment, whereas the silicon-coated iron plate produced in Example 1 showed no surface changes even after the heat treatment. Thereby, it was confirmed that oxidation did not occur in the silicon-coated anti-oxidation iron plate produced in Example 1.

From the above results, it was confirmed that the silicon-coated iron according to the present invention had oxidation resistance.

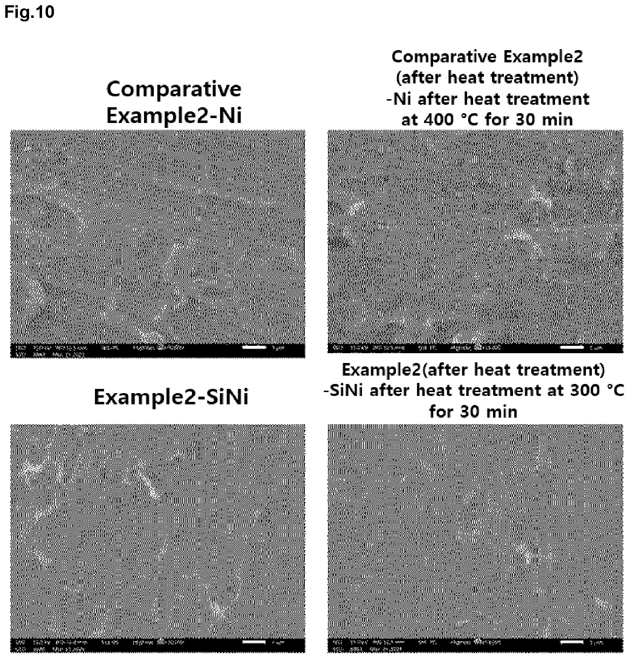

In addition, the nickel plates prepared in Example 2 and Comparative Example 2 were heat-treated at 400 °C for 30 minutes and observed by SEM at 10,000x magnification before and after the heat treatment, and the results are shown in FIG. 10.

As shown in FIG. 10, the nickel plate of Comparative Example 2 showed surface changes after the heat treatment, whereas the silicon-coated nickel plate produced in Example 2 showed no surface changes even after the heat treatment. Thereby, it was confirmed that oxidation did not occur in the silicon-coated anti-oxidation nickel plate produced in Example 2.

From the above results, it was confirmed that the silicon-coated nickel according to the present invention had oxidation resistance.

### Experimental Example 4. TEM Analysis

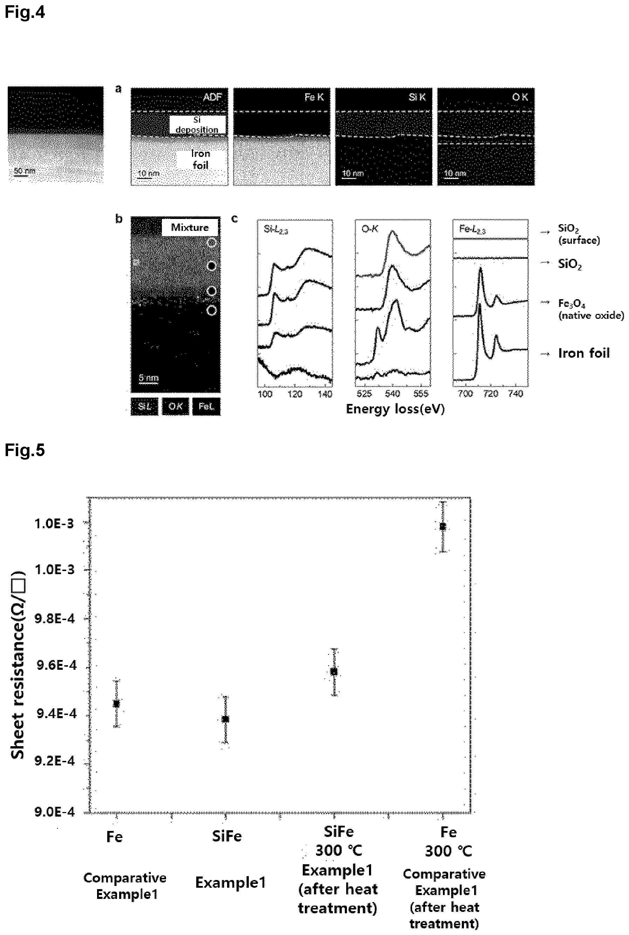

The iron plate produced in Example 1 was analyzed by TEM, and the results are shown in FIG. 4.

As shown in FIG. 4, it was confirmed that the silicon-coated iron plate was composed of the following sequential layers: an iron layer; an iron oxide (Fe₃O₄) layer formed on the iron layer; a SiFeOₓ layer formed on the iron oxide layer and consisting of the mixture of silicon (Si)-oxygen (O)-iron (Fe); and a silicon (Si)-oxygen (O) mixed layer formed on the SiFeOₓ layer.

Although the iron plate showed an iron oxide (Fe₃O₄) phase due to a native oxide formed by exposure to the air, the native oxide was formed to a very small thickness that it could not be observed with the naked eye or did not appear in the XRD results. As silicon was deposited on the native oxide, the silicon atoms fixed the freely moving oxygen atoms on the iron surface to the optimal site, thereby forming a SiFeOₓ layer. It was believed that the SiFeOₓ layer played a critical role in preventing oxidation. It was confirmed that Si-O-Fe bonds were formed.

From the above results, it was confirmed that the silicon-coated iron according to the present invention may be prevented from oxidation and have oxidation resistance at high temperatures, by including the Si-O-Fe mixed layer formed on the iron layer.

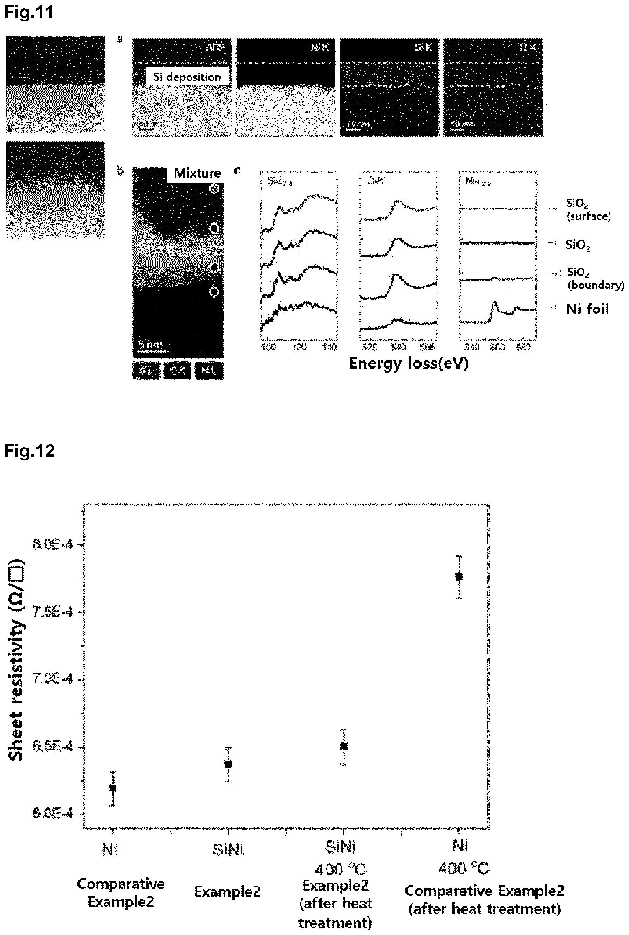

In addition, the silicon-coated nickel plate produced in Example 2 was analyzed by TEM, and the results are shown in FIG. 11.

As shown in FIG. 11, it was confirmed that the silicon-coated iron plate was composed of the following sequential layers: a nickel layer; a SiNiOₓ layer formed on the nickel layer and consisting of a mixture of silicon (Si)-oxygen (O)-nickel (Ni); a first silicon (Si)-oxygen (O) mixed layer formed on the SiNiOₓ layer; and a second silicon (Si)-oxygen (O) mixed layer formed on the first silicon (Si)-oxygen (O) mixed layer.

As silicon was deposited on the native oxide, the silicon atoms fixed the freely moving oxygen atoms on the nickel layer surface to the optimal site, thereby forming Si-O-Ni bonds. It was believed that the SiNiOₓ layer played a critical role in preventing oxidation. It was confirmed that Si-O-Fe bonds were formed.

From the above results, it was confirmed that the silicon-coated nickel according to the present invention may be prevented from oxidation and have oxidation resistance at high temperatures, by including the Si-O-Ni mixed layer formed on the nickel layer.

### Experimental Example 5. Sheet resistance Measurement

The iron plates prepared in Example 1 and Comparative Example 1 were heat-treated at 300 °C for 30 minutes and measured for their sheet resistance before and after the heat treatment, and the results are shown in FIG. 5.

As shown in FIG. 5, in the case of the iron plate of Comparative Example 1, the sheet resistance increased rapidly after the heat treatment, whereas, in the case of the silicon-coated iron plate produced in Example 1, the sheet resistance did not significantly change even after the heat treatment.

From the above results, it was confirmed that the silicon-coated iron according to the present invention has resistance to oxidation while maintaining its electrical properties.

In addition, the nickel plates prepared in Example 2 and Comparative Example 2 were heat-treated at 400 °C for 30 minutes and measured for their sheet resistance before and after the heat treatment, and the results are shown in FIG. 12.

As shown in FIG. 12, in the case of the nickel plate of Comparative Example 2, the sheet resistance increased rapidly after the heat treatment, whereas, in the case of the silicon-coated nickel plate produced in Example 1, the sheet resistance did not significantly change even after the heat treatment.

From the above results, it was confirmed that the silicon-coated nickel according to the present invention has resistance to oxidation while maintaining its electrical properties.

### Experimental Example 6. Measurement of Energy Difference Depending on Penetration Depth of Oxygen

Based on the energy outside the surface of the silicon-coated iron plate produced in Example 1, the energy when oxygen penetrated into the iron was calculated as a function of the depth from the surface, and the difference from the energy calculated when oxygen was on the sample surface is shown in FIG. 7.

As shown in FIG. 7, in the case of the silicon-coated iron plate produced in Example 1, it was found that oxygen had to overcome an energy barrier to pass through the Si-O-Fe mixed layer on the surface. Here, the energy barrier means resistance to oxidation.

From the above results, it was confirmed that the silicon-coated iron according to the present invention has resistance to oxidation.

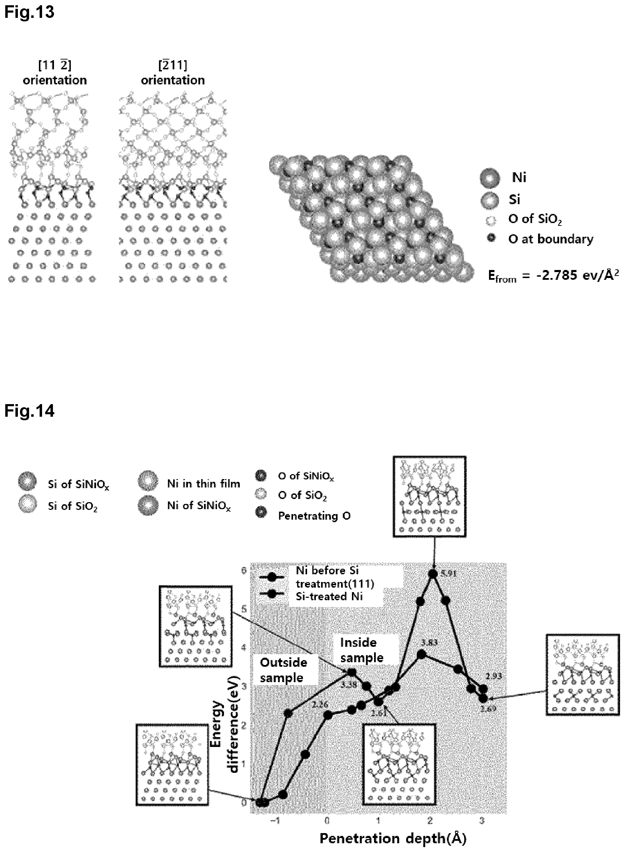

In addition, based on the energy outside the surface of the silicon-coated nickel plate produced in Example 2, the energy when oxygen penetrated into the nickel was calculated as a function of the depth from the surface, and the difference from the energy calculated when oxygen was on the sample surface is shown in FIG. 14.

As shown in FIG. 14, in the case of the silicon-coated nickel plate produced in Example 2, it was found that oxygen had to overcome an energy barrier to pass through the Si-O-Ni mixed layer on the surface. Here, the energy barrier means resistance to oxidation.

From the above results, it was confirmed that the silicon-coated nickel according to the present invention has resistance to oxidation.

### [Description of Reference Numerals]

10. Iron layer
20. Iron oxide (Fe₃O₄) layer
30. SiFeOₓ layer
40. Silicon (Si)-oxygen (O) mixed layer
100. Nickel layer (Ni)
200. SiNiOₓ layer
300. First silicon (Si)-oxygen (O) mixed layer
400. Second silicon (Si)-oxygen (O) mixed layer

## Claims

1. A silicon-coated oxidation-resistant iron comprising a SiFeOₓ layer 30 which is a silicon (Si)-oxygen (O)-iron (Fe) mixed layer formed by depositing silicon (Si).

2. The silicon-coated oxidation-resistant iron of claim 1, wherein the silicon-coated iron has an electrical resistance similar to that of non-silicon (Si)-coated iron.

3. The silicon-coated oxidation-resistant iron of claim 1, wherein the silicon-coated iron is in the form of a thin film, a foil, or a bulk.

4. The silicon-coated oxidation-resistant iron of claim 3, wherein, when the silicon-coated iron is in the form of a thin film, a foil, or a bulk, it is prevented from oxidation even when heated to 200 to 350°C for 20 minutes to 40 minutes.

5. The silicon-coated oxidation-resistant iron of claim 1, wherein the silicon-coated iron has a sheet resistance of 9.2 x 10⁻⁴ to 9.6 x 10⁻⁴ Ω/□..

6. The silicon-coated oxidation-resistant iron of claim 1, wherein the silicon-coated iron is composed of:
an iron layer 10;
an iron oxide (Fe₃O₄) layer 20 formed on the iron layer 10;
a SiFeOₓ layer formed on the iron oxide layer 20 and consisting of a mixture of (Si)-oxygen (O)-iron (Fe); and
a silicon (Si)-oxygen (O) mixed layer 40 formed on the SiFeOₓ layer 30.

7. The silicon-coated oxidation-resistant iron of claim 6, wherein the iron oxide (Fe₃O₄) layer 20 has a thickness of 3 to 7 nm.

8. The silicon-coated oxidation-resistant iron of claim 6, wherein the SiFeOₓ layer 30 consisting of the mixture of (Si)-oxygen (O)-iron (Fe) has a thickness of 0.8 to 1.2 nm.

9. The silicon-coated oxidation-resistant iron of claim 6, wherein the silicon (Si)-oxygen (O) mixed layer 40 has a thickness of 5 to 30 nm.

10. A method of producing a silicon-coated oxidation-resistant iron by depositing silicon (Si) on iron (Fe) by a single sputtering process.

11. The method of claim 10, wherein the sputtering is performed under an argon atmosphere.

12. The method of claim 10, wherein the sputtering is performed at room temperature to 350 °C for 1 to 5 minutes.

13. A silicon-coated oxidation-resistant nickel comprising a SiNiOₓ layer which is a silicon (Si)-oxygen (O)-nickel (Ni) mixed layer formed by depositing silicon (Si).

14. The silicon-coated oxidation-resistant nickel of claim 13, wherein the silicon-coated nickel has an electrical resistance similar to that of non-silicon (Si)-coated nickel.

15. The silicon-coated oxidation-resistant nickel of claim 13, wherein the silicon-coated nickel is in the form of a single-crystal thin film, a polycrystalline thin film, a foil, or a bulk.

16. The silicon-coated oxidation-resistant nickel of claim 15, wherein, when the silicon-coated nickel is in the form of a single-crystal thin film, it is prevented from oxidation even when heated to 300 to 500°C for 20 minutes to 50 minutes.

17. The silicon-coated oxidation-resistant nickel of claim 15, wherein, when the silicon-coated nickel is in the form of a polycrystalline thin film, a foil, or a bulk, it is prevented from oxidation even when heated to 200 to 400°C.

18. The silicon-coated oxidation-resistant nickel of claim 13, wherein the silicon-coated nickel has a sheet resistance of 6.2 x 10⁻⁴ to 6.8 x 10⁻⁴ Ω/□.

19. The silicon-coated oxidation-resistant nickel of claim 13, wherein the silicon-coated nickel is composed of:
a nickel layer 100;
a SiNiOₓ layer 200 formed on the nickel layer 100 and consisting of a mixture of silicon (Si)-oxygen (O)-nickel (Ni);
a first silicon (Si)-oxygen (O) mixed layer 300 formed on the SiNiOₓ layer 200; and
a second silicon (Si)-oxygen (O) mixed layer 400 formed on the first silicon (Si)-oxygen (O) mixed layer 300.

20. The silicon-coated oxidation-resistant nickel of claim 19, wherein the SiNiOₓ layer 200 has a thickness of 0.8 to 1.2 nm.

21. The silicon-coated oxidation-resistant nickel of claim 19, wherein a silicon (Si)-oxygen (O) mixed layer comprising the first silicon (Si)-oxygen (O) mixed layer 300 and the second silicon (Si)-oxygen (O) mixed layer 400 has a thickness of 5 to 30 nm.

22. A method of producing a silicon-coated oxidation-resistant nickel by depositing silicon (Si) on nickel (Ni) by a single sputtering process.

23. The method of claim 22, wherein the sputtering is performed under an argon atmosphere.

24. The method of claim 22, wherein the sputtering is performed at room temperature to 350 °C for 1 to 5 minutes.
